# EUROPEAN PATENT APPLICATION

(11) **EP 4 404 258 A1**
(43) Date of publication of application: **24.07.2024**
(21) Application number: 22869569.8
(22) Date of filing: 31.01.2022
(51) Int. Cl.: H01L 25/065, H01L 25/07, H01L 25/18, H01L 21/3205, H01L 21/768, H01L 23/522

(54) **SEMICONDUCTOR DEVICE AND METHOD FOR MANUFACTURING SEMICONDUCTOR DEVICE**

(30) Priority: 16.09.2021 JP 2021150705
(71) Applicant: Sony Semiconductor Solutions Corporation, Atsugi-shi, Kanagawa 243-0014 (JP)
(72) Inventor: FUJII, Nobutoshi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/003538
(87) International publication number: WO 2023/042416

(57) **Abstract**

To prevent a metal embedding defect in a semiconductor device in which a through-via is formed.

The semiconductor device includes a substrate, an etching stopper layer, a die, and an isolation film. In the semiconductor device, a rewiring layer is formed on the substrate. The etching stopper layer is formed on a bonding surface of the rewiring layer. The die is bonded to a partial region of the bonding surface via the etching stopper layer. The isolation film covers the die and the etching stopper layer.

## Description

### [Technical Field]

The present technology relates to a semiconductor device. Specifically, the present invention relates to a semiconductor device having a stacked structure and a method for manufacturing the semiconductor device.

### [Background Art]

In recent years, in order to improve the functionality of devices, progress has been made in the development of technology for stacking devices with different functions fabricated on separate semiconductor substrates. During this stacking, it is necessary to electrically connect the upper and lower devices after bonding the semiconductor substrates together. For example, a semiconductor device has been proposed in which wafers and dies each including a semiconductor substrate are stacked, and devices on the wafer and devices on the die are electrically connected by through-vias (for example, see PTL 1). When manufacturing this semiconductor device, after stacking the dies, an isolation film including an etching stopper layer is formed, and then through-vias are formed.

### [Citation List]

### [Patent Literature]

[PTL 1]
U.S. Patent Specification No. 9806055

### [Summary]

### [Technical Problem]

The prior art described above facilitates stacking a large number of dies using a via-last process. However, in the above-mentioned semiconductor device, when additional etching is performed after etching up to the etching stopper layer, the additional etched portion may bulge and become bowing, and metal embedding defects may occur in the bow-shaped portion when forming a through-via.

The present technology has been made in view of such a situation, and an object thereof is to prevent metal embedding defects in semiconductor devices in which through-vias are formed.

### [Solution to Problem]

The present technology has been developed to solve the above-mentioned problems, and a first aspect thereof provides a semiconductor device and a method of manufacturing the same, the semiconductor device including a substrate on which a rewiring layer is formed; an etching stopper layer formed on a bonding surface of the rewiring layer; a die bonded to a partial region of the bonding surface via the etching stopper layer; and an isolation film covering the die and the etching stopper layer. This provides the effect of preventing metal embedding defects.

Further, in this first aspect, the semiconductor device may further include a substrate-side via penetrating the isolation film and the etching stopper layer and having one end connected to a wiring in the rewiring layer; and a die-side via penetrating the isolation film, the die, and the etching stopper layer and having one end connected to the wiring in the rewiring layer. This provides the effect that the substrate is electrically connected to the die and the substrate is electrically connected to the outside.

Further, in this first aspect, the die-side via may be formed at a location that does not correspond to an end of the die. This provides the effect that the die and the substrate are electrically connected at a location that does not correspond to the end.

Further, in this first side, the die-side via may be formed at an end of the die. This provides the effect that the die-side area of the through-via and the area of the die-side electrode pad are reduced.

Further, in this first aspect, an etching rate when etching the etching stopper layer with a predetermined etching gas may be lower than an etching rate when etching the isolation film with the etching gas. This provides the effect that when etching the isolation film, the etching is stopped by the etching stopper layer.

Further, in this first aspect, the isolation film may be a silicon oxide film, and the etching stopper layer may be a layer of silicon nitride, silicon carbide, or silicon carbonitride. This provides the effect that when etching the isolation film, the etching is stopped by the etching stopper layer.

A second aspect of the present technology also provides a semiconductor device and a method for manufacturing the same, the semiconductor device including a substrate on which a rewiring layer is formed; a die bonded to a partial region of a bonding surface of the rewiring layer; a first isolation film covering the die and the rewiring layer; a second isolation film; and an etching stopper layer formed between the first and second isolation films and having a step near an end of the die. This provides the effect of preventing metal embedding defects.

Further, in the second aspect, the semiconductor device may further include a substrate-side via penetrating the first and second isolation films and the etching stopper layer and having one end connected to a wiring in the rewiring layer; and a die-side via penetrating the first and second isolation films, the etching stopper layer, and the die and having one end connected to the wiring in the rewiring layer. This provides the effect that the substrate is electrically connected to the die and the substrate is electrically connected to the outside.

Moreover, in this second side, the die-side via may be formed at a location that does not correspond to an end of the die. This provides the effect that the die and the substrate are electrically connected at a location that does not correspond to the end.

Moreover, in this second side, the die-side via may be formed at an end of the die. This provides the effect that the die-side area of the through-via and the area of the die-side electrode pad are reduced.

### [Brief Description of Drawings]

[Fig. 1]

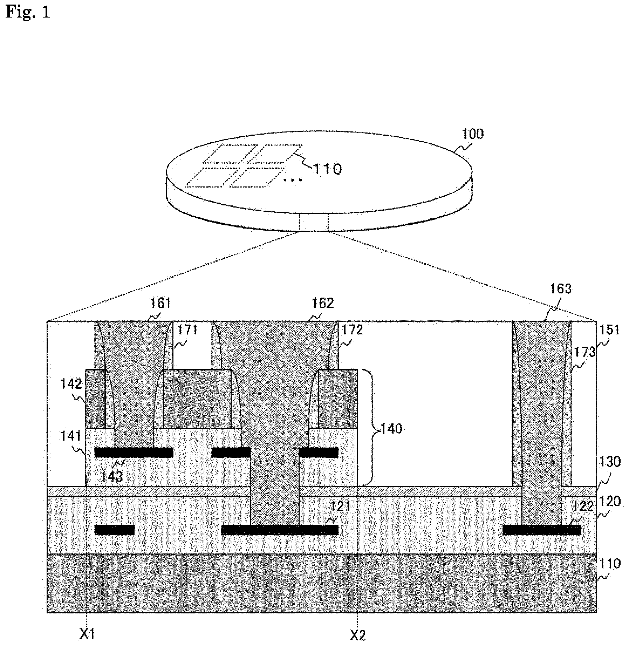

   Fig. 1 is a cross-sectional view showing an example of the configuration of a wafer in a first embodiment of the present technology.
[Fig. 2]

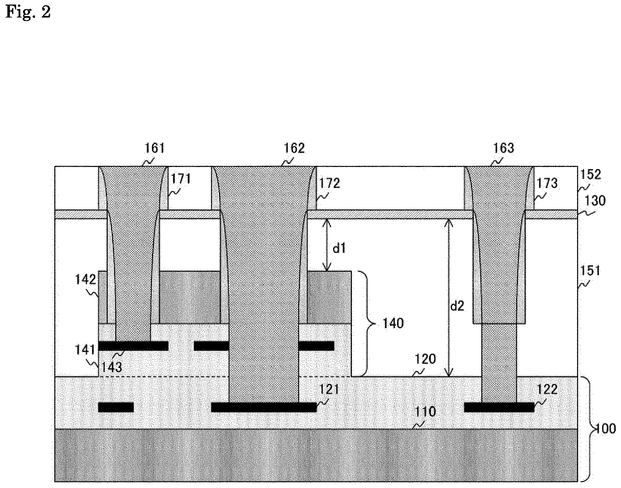

   Fig. 2 is a cross-sectional view showing an example of the configuration of a wafer in a comparative example.
[Fig. 3]

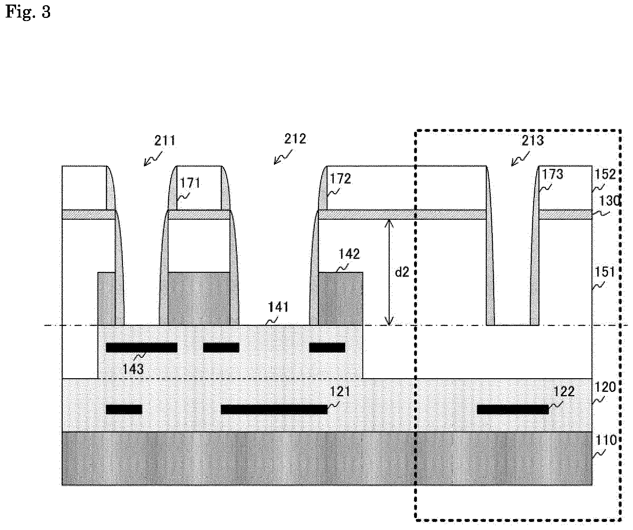

   Fig. 3 is an example of a cross-sectional view of a wafer on which sidewalls are formed in a comparative example.
[Fig. 4]

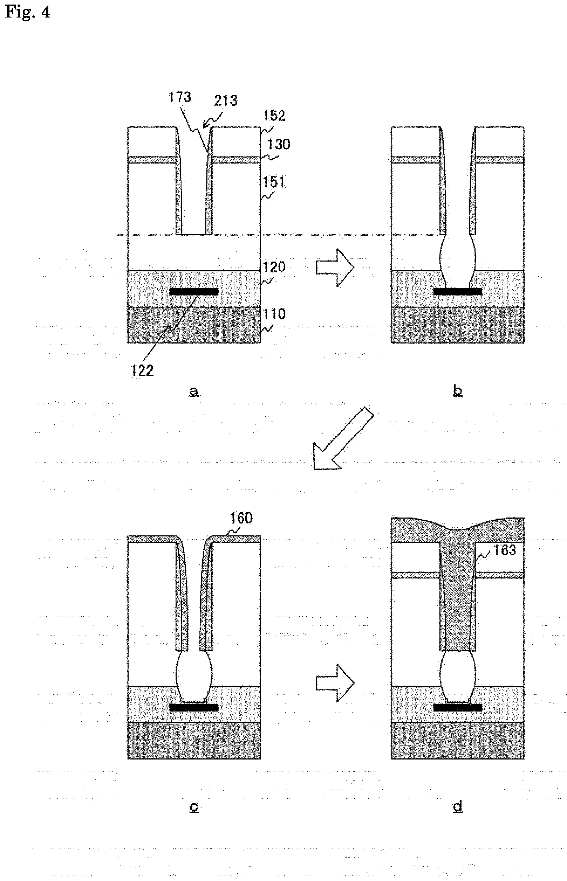

   Fig. 4 is a diagram for explaining the procedures up to metal embedding in a comparative example.
[Fig. 5]

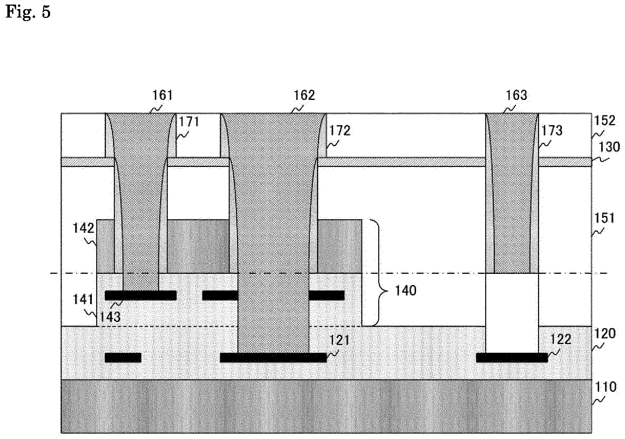

   Fig. 5 is an example of a cross-sectional view of a wafer in which an embedding defect occurred in a comparative example.
[Fig. 6]

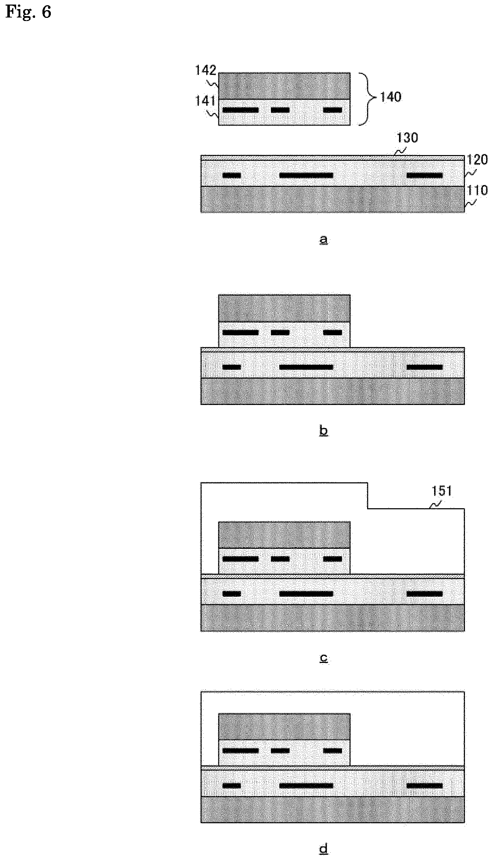

   Fig. 6 is a diagram for explaining the procedures up to CMP (Chemical Mechanical Polishing) of an isolation film in the first embodiment of the present technology.
[Fig. 7]

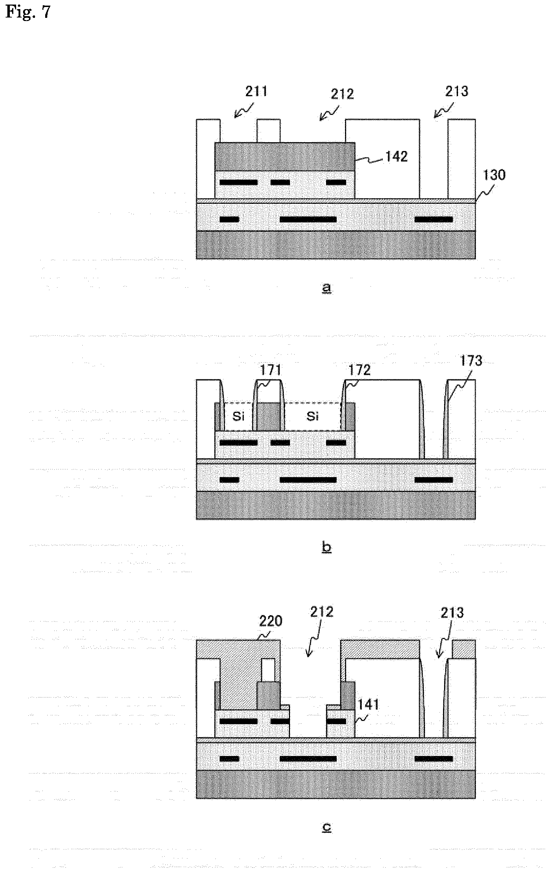

   Fig. 7 is a diagram for explaining the procedures up to the etching of a die-side rewiring layer in the first embodiment of the present technology.
[Fig. 8]

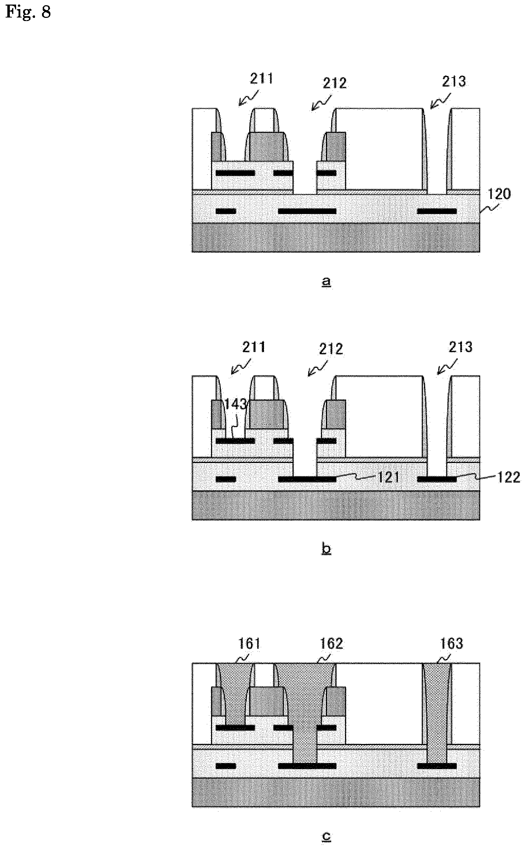

   Fig. 8 is a diagram for explaining the procedures up to metal embedding and CMP in the first embodiment of the present technology.
[Fig. 9]

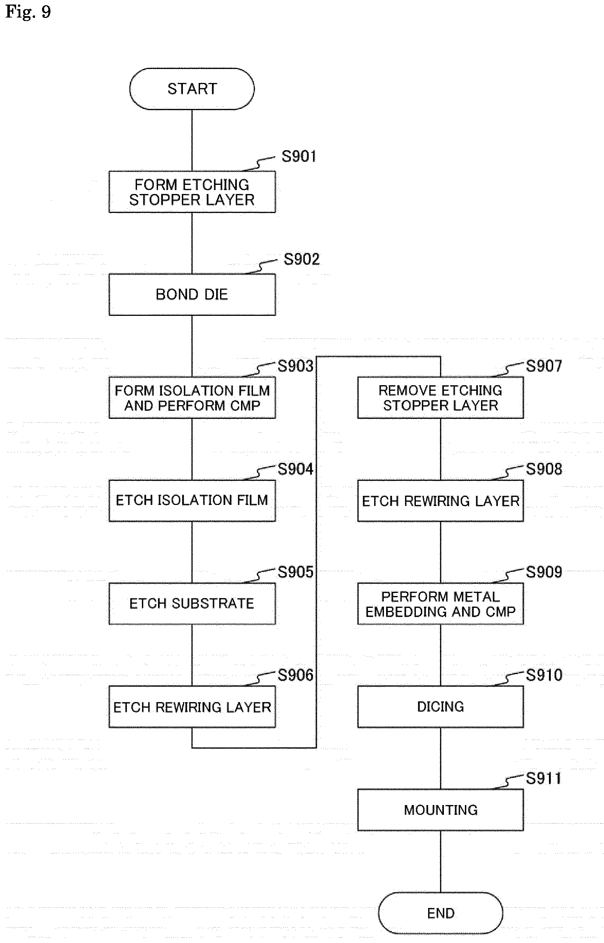

   Fig. 9 is a flowchart illustrating an example of a method for manufacturing a semiconductor device according to the first embodiment of the present technology.
[Fig. 10]

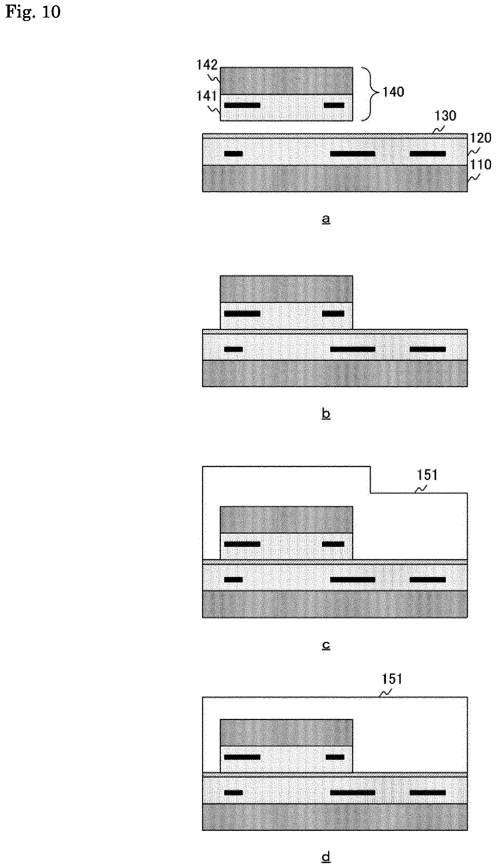

   Fig. 10 is a diagram for explaining the procedures up to CMP of an isolation film in a second embodiment of the present technology.
[Fig. 11]

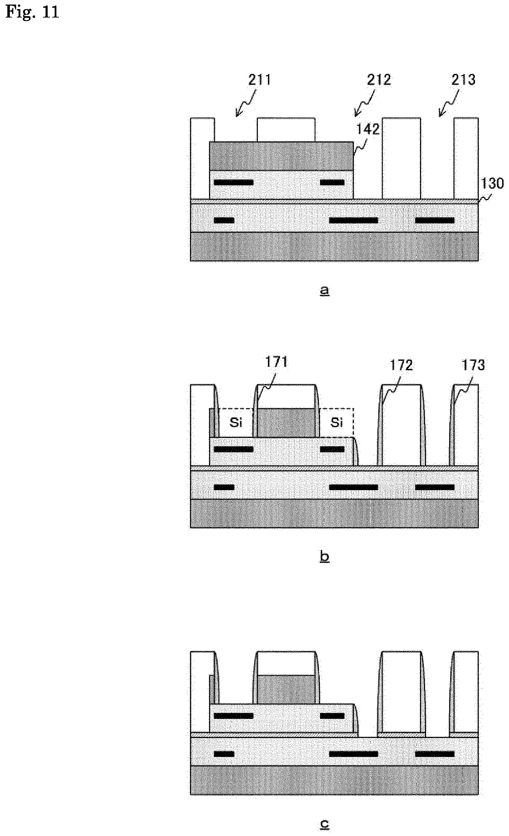

   Fig. 11 is a diagram for explaining the procedures up to the removal of an etching stopper layer in the second embodiment of the present technology.
[Fig. 12]

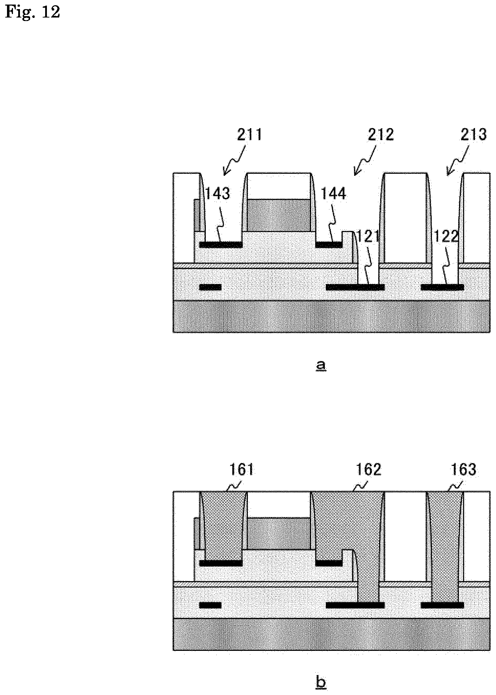

   Fig. 12 is a diagram for explaining the procedures up to metal embedding and CMP in the second embodiment of the present technology.
[Fig. 13]

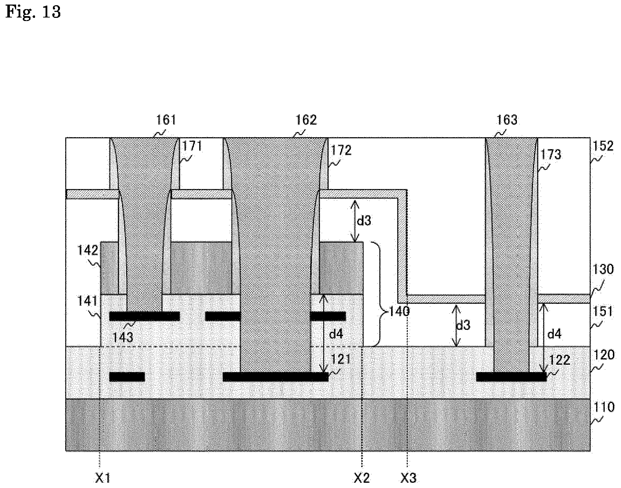

   Fig. 13 is a cross-sectional view showing an example of the configuration of a wafer in a third embodiment of the present technology.
[Fig. 14]

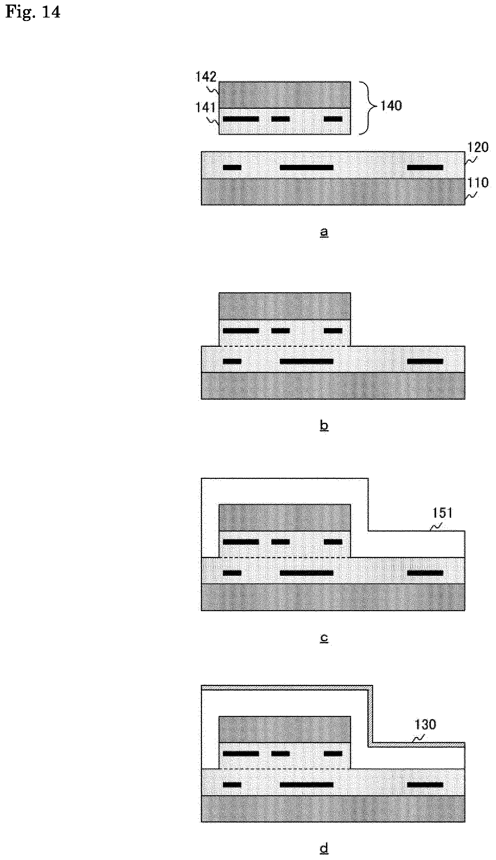

   Fig. 14 is a diagram for explaining the procedures up to the formation of an etching stopper layer in the third embodiment of the present technology.
[Fig. 15]

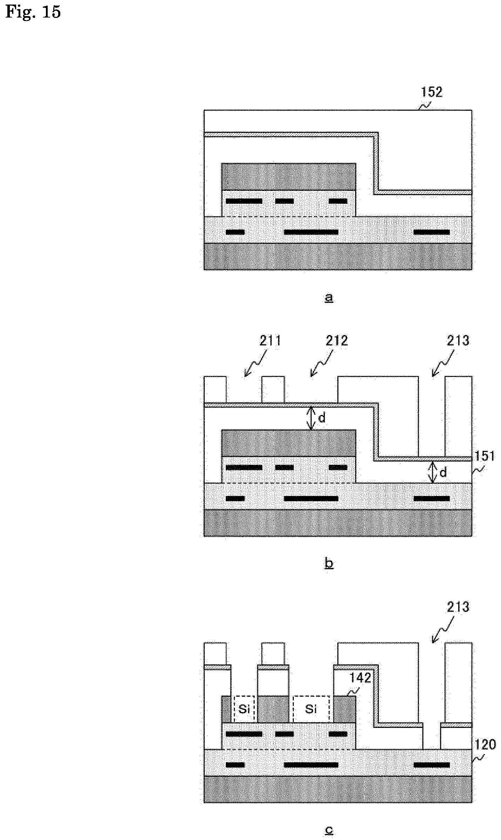

   Fig. 15 is a diagram for explaining the procedures up to substrate etching in the third embodiment of the present technology.
[Fig. 16]

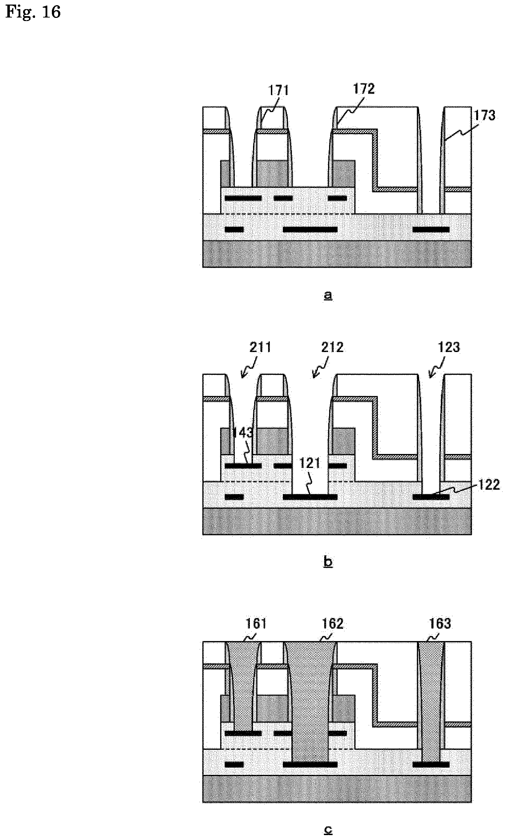

   Fig. 16 is a diagram for explaining the procedures up to metal embedding and CMP in the third embodiment of the present technology.
[Fig. 17]

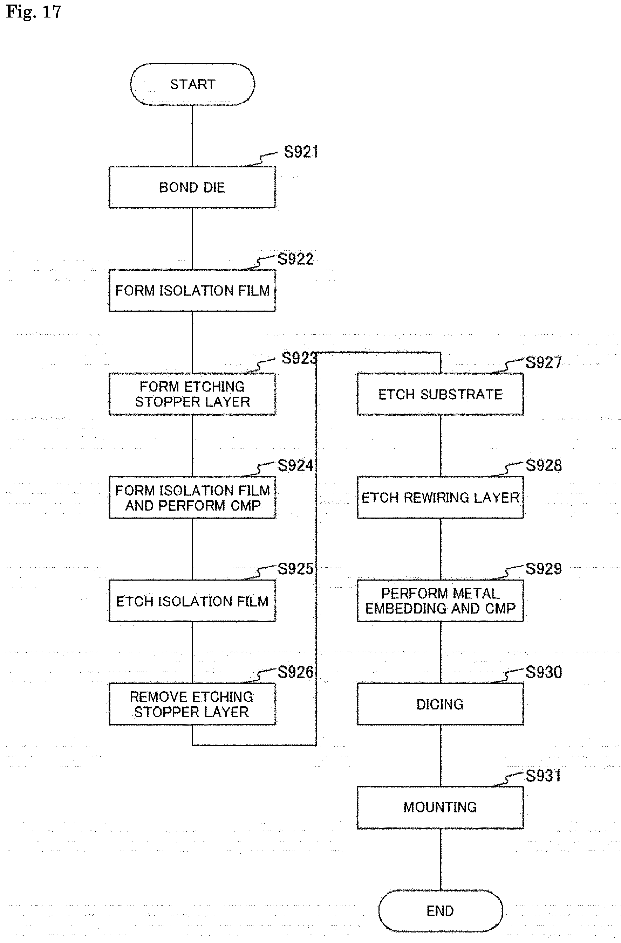

   Fig. 17 is a flowchart illustrating an example of a method for manufacturing a semiconductor device according to the third embodiment of the present technology.
[Fig. 18]

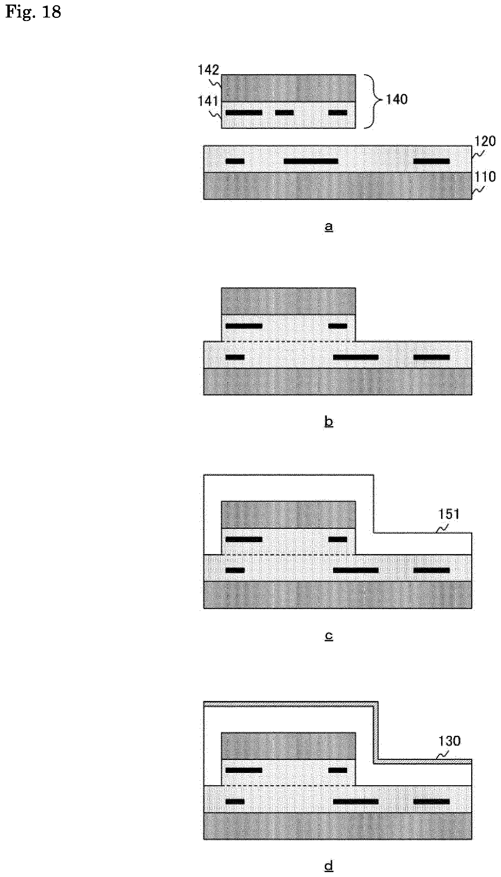

   Fig. 18 is a diagram for explaining the procedures up to the formation of an etching stopper layer in a fourth embodiment of the present technology.
[Fig. 19]

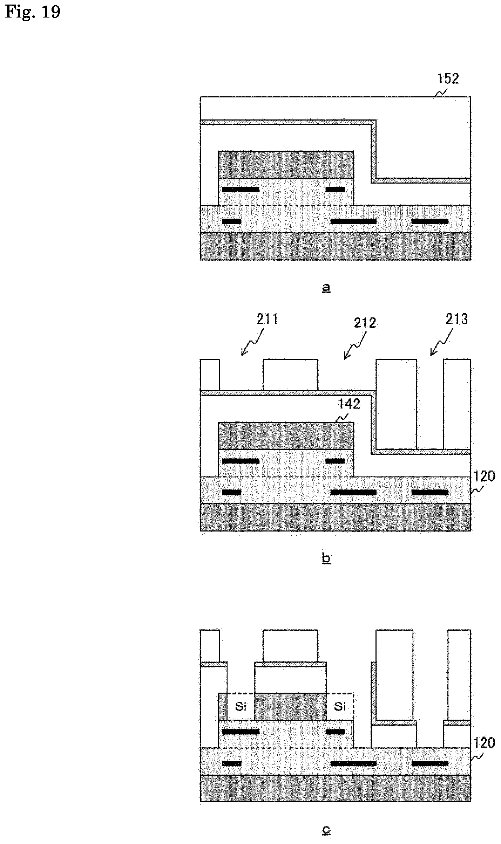

   Fig. 19 is a diagram for explaining the procedures up to substrate etching in the fourth embodiment of the present technology.
[Fig. 20]

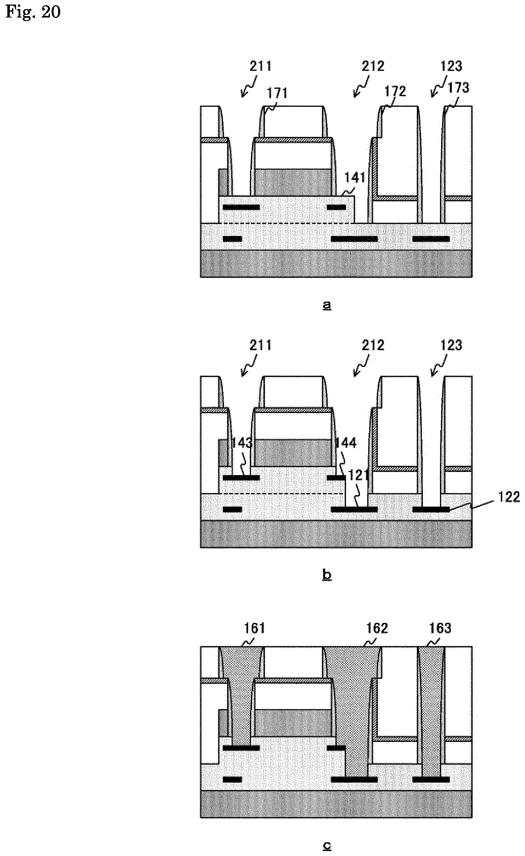

   Fig. 20 is a diagram for explaining the procedures up to metal embedding and CMP in the fourth embodiment of the present technology.
[Fig. 21]

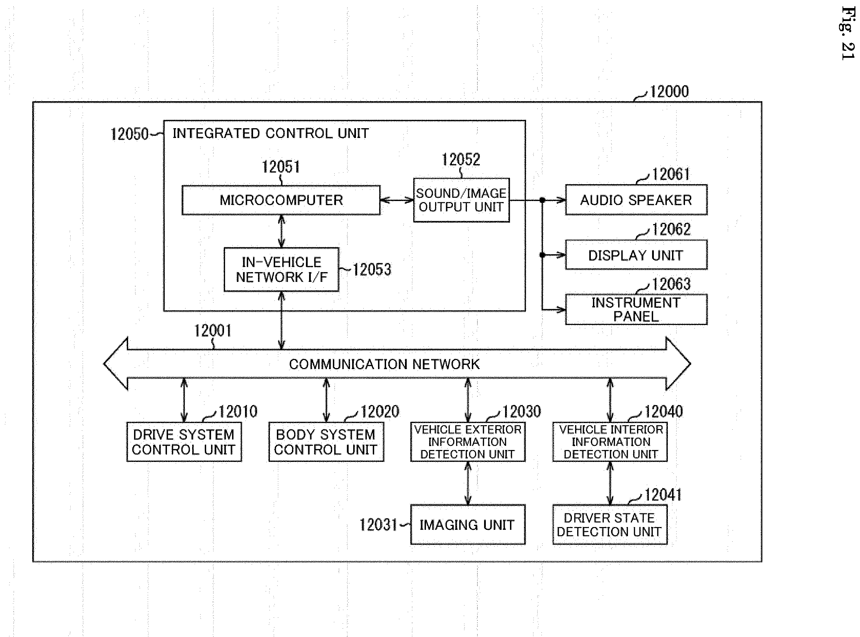

   Fig. 21 is a block diagram illustrating a schematic configuration example of a vehicle control system.
[Fig. 22]

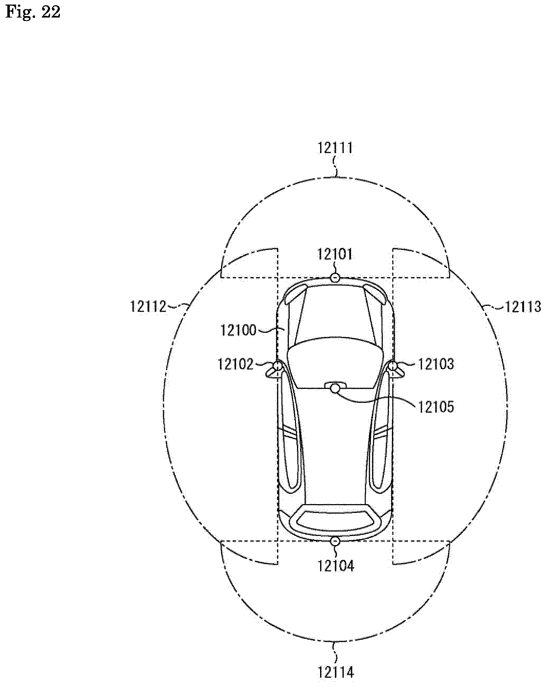

   Fig. 22 is a diagram illustrating an example of an installation position of an imaging unit.

### [Description of Embodiments]

Modes for carrying out the present technology (hereinafter also referred to as "embodiments") will be described below. The description will be given in the following order.
1. First embodiment (example in which etching stopper layer is formed on bonding surface)
2. Second embodiment (example in which etching stopper layer is formed on bonding surface and through-via is provided at end of die)
3. Third embodiment (example in which step is provided in etching stopper layer)
4. Fourth embodiment (example in which step is provided in etching stopper layer and through-via is provided at end of die)
5. Exemplary application to moving body

### <1. First embodiment>

### [Wafer configuration example]

Fig. 1 is a cross-sectional view showing an example of the configuration of a wafer 100 in a first embodiment of the present technology. This wafer 100 includes a plurality of substrates 110. A dotted parallelogram in the figure indicates the substrate 110. A rewiring layer 120 is formed on each substrate 110. Hereinafter, the direction from the substrate 110 to the rewiring layer 120 will be referred to as the "up" direction. Further, the entire upper surface of the rewiring layer 120 is defined as a "bonding surface." Wirings 121, 122, and the like are wired in this rewiring layer 120.

Further, a die 140 including a substrate 142 and a rewiring layer 141 stacked on each other is stacked on the wafer 100 including the substrate 110 and the rewiring layer 120. The wafer-side substrate 110 and the die-side substrate 142 are rectangular when viewed from above, and the area of the wafer-side substrate 110 is larger than the die-side substrate 142.

An etching stopper layer 130 is formed on the bonding surface of the rewiring layer 120. The die 140 is bonded to a partial region of the bonding surface of the rewiring layer 120 via this etching stopper layer 130. In the figure, a region from coordinate X1 to coordinate X2 indicates a region where the die 140 is bonded. In the die 140, the rewiring layer 141 is on the lower side of the substrate 142, and the rewiring layer 141 is bonded to the bonding surface via the etching stopper layer 130. In addition, wirings 143 and the like are wired in the rewiring layer 141.

Further, the upper parts of the die 140 and the etching stopper layer 130 are covered with an isolation film 151. Since the area of the die 140 is smaller than the wafer-side substrate 110, the upper and side surfaces of the die 140 are covered with the isolation film 151.

Furthermore, the die 140 is electrically connected to the outside by a through-via 161. This through-via 161 penetrates the isolation film 151 on the upper part of the die 140 and the die-side substrate 142, and has one end connected to the die-side wiring 143 and the other end exposed to the upper surface of the isolation film 151.

Further, the die 140 and the wafer 100 are electrically connected by a through-via 162. This through-via 162 penetrates the isolation film 151 on the upper part of the die 140 and the die 140 and the etching stopper layer 130, and has one end connected to the wafer-side wiring 121 and the other end exposed to the upper surface of the isolation film 151. Further, the through-via 162 is formed at a location that does not correspond to the end of the die 140. In the figure, coordinates X1 and X2 correspond to the ends of the die 140. Note that the through-via 162 is an example of a die-side via described in the claims.

Further, the wafer 100 is electrically connected to the outside by a through-via 163. This through-via 163 penetrates the isolation film 151 on the side surface of the die 140 and the etching stopper layer 130, and has one end connected to the wafer-side wiring 122 and the other end exposed to the upper surface of the isolation film 151. Note that the through-via 163 is an example of a substrate-side via described in the claims.

Here, the etching stopper layer 130 is a film for stopping etching when the isolation film 151 is etched, and has a different composition from the isolation film 151. As the material of this etching stopper layer 130, a material whose etching rate when etching with a certain etching gas is lower than the etching rate when etching the isolation film 151 with that etching gas is used. For example, a silicon oxide film is used as the isolation film 151, and a layer of silicon nitride (SiN), silicon carbide (SiC), or silicon carbonitride (SiCN) is used as the etching stopper layer 130.

Further, the etching stopper layer 130 is thinner than the isolation film 151. For example, the thickness of the etching stopper layer 130 is 50 nanometers (nm), and the thickness of the isolation film 151 is 5000 nanometers (nm).

The wafer 100 illustrated in the figure is divided into a plurality of wafer-level semiconductor packages by dicing. The semiconductor package is mounted on various semiconductor devices such as solid-state image sensors.

Here, as a comparative example, a wafer is assumed in which the etching stopper layer 130 is not formed on the bonding surface but is formed on the top of the bonding surface.

Fig. 2 is a cross-sectional view showing an example of the configuration of a wafer 100 in a comparative example. Details of this comparative example are described in PTL 1. In the comparative example, the etching stopper layer 130 is not formed on the bonding surface, but is formed on the top of the bonding surface. More specifically, the bonding surface of the rewiring layer 120 and the upper and side surfaces of the die 140 are covered with the isolation film 151. The etching stopper layer 130 is formed on the upper surface of this isolation film 151, and the upper surface of the etching stopper layer 130 is covered with an isolation film 152.

Further, the etching stopper layer 130 of the comparative example has no step. On the other hand, there is a step between the die 140 and the bonding surface around it. Therefore, the distance d1 from the upper surface of the die 140 to the etching stopper layer 130 and the distance d2 from the bonding surface around the die 140 to the etching stopper layer 130 have different values.

When manufacturing the wafer 100 of the comparative example, the manufacturing system bonds the die 140 and forms the isolation film 151, the etching stopper layer 130, and the isolation film 152 in this order. The manufacturing system then etches the upper isolation film 152 up to the etching stopper layer 130 to form openings 211, 212, and 213 (not shown). The openings 211 and 212 are formed on the top of the die 140 and the opening 213 is formed on the wafer side around the die 140. Subsequently, the manufacturing system etches the exposed etching stopper layer 130 and etches the isolation film 151 under each of the openings 211 to 213 up to the rewiring layer 141 to form sidewalls 171 to 173.

Fig. 3 is an example of a cross-sectional view of a wafer on which the sidewalls 171 and the like are formed in a comparative example. The one-dot chain line in the figure indicates a plane whose distance from the etching stopper layer 130 is d2. The die-side openings 211 and 212 are etched up to the rewiring layer 141. On the other hand, the etching of the wafer-side opening 213 stops at a one-dot chain line in the middle of the isolation film 151.

Fig. 4 is a diagram for explaining the procedures up to metal embedding in a comparative example. Fig. 4(a) shows a cross-sectional view of a portion surrounded by a dotted line near the opening 213 illustrated in Fig. 3.

As illustrated in Fig. 4(b), the manufacturing system etches the isolation film 152 and the rewiring layer 120 below the opening 213 up to the wiring 122. Since the formation of the sidewall 173 stops at the one-dot chain line, the portion where additional etching is performed may become bowing.

As illustrated in Fig. 4(c), the manufacturing system forms a seed layer 160 of metal (such as copper) by BM (Balanced Magnetron) sputtering. Then, the manufacturing system embeds the metal in the opening 213 by electrolytic plating to form the through-via 163, as illustrated in Fig. 4(d). During this electrolytic plating, if there is a bow-shaped portion, the metal will not penetrate into that portion, increasing the possibility of breakage. This metal embedding defect causes a connection defect in the electrical connection between the wafer 100 and the outside.

Fig. 5 is an example of a cross-sectional view of a wafer 100 in which an embedding defect occurred in a comparative example. In the comparative example, depending on the conditions, an embedding defect may not occur as illustrated in Fig. 2, but an embedding defect may occur as illustrated in Fig. 5.

On the other hand, as illustrated in Fig. 1, in the wafer 100 of the first embodiment in which the etching stopper layer 130 is formed on the bonding surface, it is possible to prevent metal embedding defects during manufacturing. Next, a method for manufacturing the wafer 100 according to the first embodiment will be described.

### [Wafer manufacturing method]

Fig. 6 is a diagram for explaining the procedures up to CMP of the isolation film 151 in the first embodiment of the present technology. As illustrated in Fig. 6(a), the manufacturing system forms a 50-nanometer (nm) silicon nitride layer as an etching stopper layer 130 on the bonding surface of the wafer-side rewiring layer 120. The manufacturing system also manufactures a die 140 that is rectangular when viewed from above.

As illustrated in Fig. 6(b), the manufacturing system directly bonds the die 140 to the wafer-side rewiring layer 120 via the etching stopper layer 130. Note that the die 140 can also be bonded using a thin adhesive instead of being directly bonded. At this time, the die 140 is set to have a thickness of 300 micrometers (pm) for easy handling, but if the transistor could operate after bonding, it should be as thin as possible so that later processing becomes easier. For this reason, the manufacturing system uses a grinder to grind the substrate 142 to a thickness of 1 micrometer (pm), and polishes the upper surface of the substrate 142 to make it flat.

Then, as illustrated in Fig. 6(c), the manufacturing system forms a 5000-nanometer (nm) silicon oxide film as an isolation film 151 from the upper surface of the die 140. The isolation film 151 above the die 140 is higher than its surroundings by the thickness of the die 140.

Therefore, the manufacturing system applies a resist agent and exposes it to light to open only the upper part of the die 140, and then etches the isolation film 151 by dry etching.

In this way, as illustrated in Fig. 6(d), the heights of the isolation film 151 on the upper part of the die 140 and the isolation film 151 in the surrounding part can be made almost the same. After that, the manufacturing system performs CMP to eliminate a step on the upper surface of the isolation film 151 and flatten the upper surface.

Fig. 7 is a diagram for explaining the procedures up to etching the die-side rewiring layer 141 in the first embodiment of the present technology.

After flattening the upper surface of the isolation film 151, as illustrated in Fig. 7(a), the manufacturing system applies a resist agent and exposes it to light to open only the through-via portion, and then etches the isolation film 151 by dry etching. As a result, openings 211 to 213 are formed. At this time, the etching of the isolation film 151 stops at the silicon substrate 142 on the die side, and stops at the etching stopper layer 130 on the wafer side. Unlike the third embodiment and comparative example described later, in the first embodiment, the isolation films can be etched all at once.

On the die side, since the silicon substrate 142 is exposed, the manufacturing system selects a gas for etching only silicon and etches the substrate 142, as illustrated in Fig. 7(b). When the silicon etching is completed, silicon oxide films are formed as sidewalls 171 to 173 on the sidewalls of the openings 211 to 213 to insulate the metal filled in those openings.

Thereafter, as illustrated in Fig. 7(c), the manufacturing system fills the die-side opening 211 with a resist 220, leaving the openings 212 and 213 corresponding to the through-vias 162 and 163 that penetrate to the wafer side and then etches the rewiring layer 141. Although the silicon oxide rewiring layer 141 is exposed through the opening 212, its etching stops at the etching stopper layer 130.

As illustrated in the figure, by forming the etching stopper layer 130 on the bonding surface, when etching the isolation film 151, there is no need to stop the etching midway unlike the comparative example. This eliminates the occurrence of bow-shaped portions during etching and prevents metal embedding defects.

Fig. 8 is a diagram for explaining the procedures up to metal embedding and CMP in the first embodiment of the present technology.

As illustrated in Fig. 8(a), the manufacturing system removes the resist 220. Then, as illustrated in Fig. 8(b), the manufacturing system etches the rewiring layers 141 and 120 up to the electrode pads (not shown) on the wirings 143, 121, and 122.

Then, as illustrated in Fig. 8(c), through-vias 161 to 163 are formed. At this time, the manufacturing system creates a stacked structure in which titanium nitride and titanium are each deposited to a thickness of 50 nanometers (nm) as a diffusion prevention film to prevent the diffusion of metal (copper), and then forms a thin copper film of 100 nanometers (nm) film by sputtering on the stacked structure. Thereafter, the manufacturing system fills the openings 211 to 213 with copper by electrolytic plating, and then removes the copper covering the surface and the diffusion prevention layer by CMP to form the shape shown in Fig. 8(c).

Fig. 9 is a flowchart illustrating an example of a method for manufacturing a semiconductor device according to the first embodiment of the present technology. The semiconductor device manufacturing system forms an etching stopper layer 130 on the bonding surface of the wafer-side rewiring layer 120 (step S901), and bonds the die 140 to the bonding surface via the etching stopper layer 130 (step S902). Note that step S901 is an example of an etching stopper layer forming procedure described in the claims, and step S902 is an example of a bonding procedure described in the claims.

Then, the manufacturing system forms an isolation film 151 that covers the die 140 and the etching stopper layer 130, and performs CMP (step S903). The manufacturing system etches the isolation film 151 to form the openings 211 to 213 (step S904). The die-side openings 211 and 212 penetrate the isolation film 151 and reach the die 140, and the wafer-side opening 213 penetrates the isolation film 151 and reaches the etching stopper layer 130.

Note that the opening 212 is an example of a die-side opening described in the claims, and the opening 213 is an example of a substrate-side opening described in the claims.
Further, step S903 is an example of an isolation film forming procedure described in the claims.

Subsequently, the manufacturing system etches the substrate 142 of the die 140 exposed through the openings 211 and 212 (step S905), and etches the rewiring layer 141 exposed through the openings 212 up to the etching stopper layer 130 (step S906).

The manufacturing system removes the etching stopper layer 130 exposed through the openings 212 to 213 (step S907), and etches the exposed rewiring layer 120 (step S908).

Then, the manufacturing system forms the through-vias 161 to 163 by filling the openings 211 to 213 with metal (copper) or by CMP (step S909). Note that step S909 is an example of a via forming procedure described in the claims.

The manufacturing system manufactures a plurality of semiconductor packages by dicing (step S910), and manufactures a semiconductor device by mounting these semiconductor packages (step S911).

As described above, according to the first embodiment of the present technology, since the etching stopper layer 130 is formed on the bonding surface, there is no need to stop etching midway when etching the isolation film 151, and a bow-shaped portion no longer occurs. As a result, it is possible to prevent metal embedding defects.

### <2. Second embodiment>

In the first embodiment described above, the die-side through-via 162 was formed at a position away from the end of the die 140, but in this configuration, it is difficult to further reduce the die-side area of the through-via 162 and the area of the die-side electrode pad. The wafer 100 in this second embodiment differs from the first embodiment in that the through-via 162 is formed at the end of the die 140.

Fig. 10 is a diagram for explaining the procedures up to CMP of the isolation film 151 in the second embodiment of the present technology. Each of the procedures up to CMP of the isolation film 151 in this second embodiment is the same as in the first embodiment.

Fig. 11 is a diagram for explaining the procedures up to the removal of the etching stopper layer 130 in the second embodiment of the present technology. In this second embodiment, the manufacturing system forms an opening 212 at the end of the die 140, as illustrated in Fig. 11(a). A portion of the opening 212 reaches the substrate 142 of the die 140, and the rest reaches the etching stopper layer 130. The positions of the openings 211 and 213 in the second embodiment are the same as in the first embodiment.

The manufacturing system etches the silicon substrate 142 as illustrated in Fig. 11(b), and removes the etching stopper layer 130 as illustrated in Fig. 11(c).

Fig. 12 is a diagram for explaining the procedures up to metal embedding and CMP in the second embodiment of the present technology.

At the same time, the manufacturing system etches the rewiring layers 141 and 120 up to the electrode pads of the wirings 143, 144, 121, and 122, respectively, as illustrated in a. Then, the manufacturing system forms through-vias 161 to 163 by embedding metal (copper) or CMP, as illustrated in Fig. 12(b).

By opening the end of the die 140 and forming the through-via 162, the die-side area of the through-via 162 and the area of the die-side electrode pad can be reduced compared to the first embodiment. This improves the degree of freedom in wiring within the die and allows the size of the die to be reduced. Furthermore, there is no need to fill the die-side opening 211 with the resist 220.

As described above, according to the second embodiment of the present technology, since the through-via 162 is formed at the end of the die 140, the die-side area of the through-via 162 and the area of the die-side electrode pad can be reduced.

### <3. Third embodiment>

In the first embodiment described above, the etching stopper layer 130 is formed on the bonding surface of the rewiring layer 120, but the position of the etching stopper layer 130 is not limited to the bonding surface. The wafer 100 of the third embodiment differs from the first embodiment in that an etching stopper layer 130 with a step is formed above the bonding surface.

Fig. 13 is a cross-sectional view showing an example of the configuration of a wafer 100 in the third embodiment of the present technology. In this third embodiment, the etching stopper layer 130 is not formed on the bonding surface of the rewiring layer 120, but is formed between the isolation film 151 and the isolation film 152 on the bonding surface. Furthermore, a step is provided in the etching stopper layer 130 at the coordinate X3 near the end of the die 140. This step is formed such that the die-side etching stopper layer 130 is higher than the wafer-side etching stopper layer 130. Due to this step, the distance from the die-side substrate 142 to the etching stopper layer 130 and the distance from the rewiring layer 120 to the etching stopper layer 130 have approximately the same value d3.

The wafer-side through-via 163 penetrates the isolation films 151 and 152 and the etching stopper layer 130 and has one end connected to the wiring 122 in the rewiring layer 120. Furthermore, the die-side through-via 162 penetrates the isolation films 151 and 152, the etching stopper layer 130, and the die 140, and has one end connected to the wiring 121 in the rewiring layer 120. The die-side through-via 161 penetrates the isolation films 151 and 152, the etching stopper layer 130, and the substrate 142, and has one end connected to the wiring 143 in the rewiring layer 141.

Furthermore, the distance from the upper surface of the rewiring layer 141 to the electrode pad in the rewiring layer 120 and the distance from the etching stopper layer 130 to the electrode pad in the rewiring layer 120 have approximately the same value d4. Therefore, the amount of processing of the insulating film (rewiring layer and isolation film) is uniform, and processing becomes easy.

Note that the isolation film 151 is an example of a first isolation film described in the claims, and the isolation film 152 is an example of a second isolation film described in the claims.

Fig. 14 is a diagram for explaining the procedures up to the formation of the etching stopper layer 130 in the third embodiment of the present technology. As illustrated in Fig. 14(a), the manufacturing system manufactures a die 140 that is rectangular when viewed from above. The etching stopper layer 130 is not formed on the wafer-side bonding surface.

As illustrated in Fig. 14(b), the manufacturing system directly bonds the die 140 to the wafer-side rewiring layer 120. Note that the die 140 can also be bonded using a thin adhesive instead of being directly bonded.

Then, as illustrated in Fig. 14(c), the manufacturing system forms a 5000-nanometer (nm) silicon oxide film as an isolation film 151 from the upper surface of the die 140.

Furthermore, as illustrated in Fig. 14(d), the manufacturing system forms a 50-nanometer (nm) silicon nitride layer as the etching stopper layer 130.

Fig. 15 is a diagram for explaining the procedures up to the etching of the substrate 142 in the third embodiment of the present technology.

As illustrated in Fig. 15(a), the manufacturing system forms a 5000-nanometer (nm) silicon oxide layer covering the etching stopper layer 130 as an isolation film 152. At this time, the isolation film 152 above the die 140 is higher than its surroundings by the thickness of the die 140.

Therefore, the manufacturing system applies a resist agent and exposes it to light to open only the upper part of the die 140, and then etches the isolation film 152 by dry etching.

In this way, the heights of the isolation film 152 on the upper part of the die 140 and the isolation film 152 in the surrounding part can be made almost the same. Thereafter, the manufacturing system performs CMP to eliminate the step on the upper surface of the isolation film 152 and flatten the upper surface.

As illustrated in Fig. 15(b), after flattening, the manufacturing system applies a resist agent and exposes it to light to open only the through-via portions, and then etches the isolation film 152 by dry etching. As a result, the openings 211 to 213 are formed. Although the thickness of the isolation film 152 is different between the upper part of the die 140 and the other parts, the etching of the upper part of the die 140 is stopped by the etching stopper layer 130 until the etching of the thicker one is completed.

The manufacturing system removes the resist, etches only the etching stopper layer 130 exposed through the openings 211 to 213 with another gas, and removes the etching stopper layer 130. The manufacturing system then etches the isolation film 151 exposed through the openings 211 to 213. At this time, due to the step in the etching stopper layer 130, the thickness of the etching stopper layer 130 is the same (for example, 300 nanometers) between the upper part of the die 140 and the part around the die 140. Therefore, once the rewiring layer 120 is etched, the die-side substrate 142 is exposed.

On the die side, since the silicon substrate 142 is exposed, the manufacturing system selects a gas for etching only silicon and etches the substrate 142, as illustrated in Fig. 15(c).

As illustrated in the figure, since a step is provided in the etching stopper layer 130, there is no need to stop etching on the wafer side midway when etching the isolation film 151 after removing the etching stopper layer 130 unlike the comparative example. This eliminates the occurrence of bow-shaped portions during etching and prevents metal embedding defects.

Fig. 16 is a diagram for explaining the procedures up to metal embedding and CMP in the third embodiment of the present technology.

As illustrated in Fig. 16(a), the manufacturing system forms silicon oxide films as sidewalls 171 to 173 on the sidewalls of the openings 211 to 213 to insulate the metal filled in those openings. Then, as illustrated in Fig. 16(b), the manufacturing system etches the rewiring layers 141 and 120 up to the electrode pads (not shown) on the wirings 143, 121, and 122.

Then, as illustrated in Fig. 16(c), through-vias 161 to 163 are formed.

Fig. 17 is a flowchart illustrating an example of a method for manufacturing a semiconductor device according to the third embodiment of the present technology. The manufacturing system bonds the die 140 to the bonding surface of the wafer-side rewiring layer 120 (step S921), and forms the isolation film 151 that covers the die 140 and the rewiring layer 120 (step S922). Note that step S921 is an example of a first isolation film forming procedure described in the claims.

Then, the manufacturing system forms the etching stopper layer 130 having a step near the end of the die 140 (step S923), forms the isolation film 152 to cover the etching stopper layer 130, and performs CMP (step S924). Note that step S924 is an example of a second isolation film forming procedure described in the claims.

The manufacturing system etches the isolation film 152 to form the openings 211 to 213 (step S925). The die-side openings 211 and 212 penetrate the isolation film 151 and reach the die-side etching stopper layer 130, and the wafer-side opening 213 penetrates the isolation film 151 and reaches the wafer-side etching stopper layer 130.

The manufacturing system removes the etching stopper layer 130 exposed through the openings 211 to 213 (step S926), and etches the exposed substrate 142 (step S927). Furthermore, the manufacturing system etches the exposed rewiring layer 141 and rewiring layer 120 (step S928).

Then, the manufacturing system forms the through-vias 161 to 163 by filling the openings 211 to 213 with metal (copper) or by CMP (step S929).

The manufacturing system manufactures a plurality of semiconductor packages by dicing (step S930), and manufactures a semiconductor device by mounting these semiconductor packages (step S931).

As described above, according to the third embodiment of the present technology, since the step is provided in the etching stopper layer 130, there is no need to stop the etching on the wafer side midway when etching the isolation film 151 after removing the etching stopper layer 130. This eliminates the occurrence of bow-shaped portions during etching and prevents metal embedding defects.

### <4. Fourth embodiment>

In the third embodiment described above, the die-side through-via 162 is formed at a position away from the end of the die 140, but in this configuration, it is difficult to further reduce the die-side area of the through-via 162 and the area of the die-side electrode pad. The wafer 100 in this fourth embodiment differs from the third embodiment in that a through-via 162 is formed at the end of the die 140.

Fig. 18 is a diagram for explaining the procedures up to the formation of the etching stopper layer 130 in the fourth embodiment of the present technology. The procedures up to the formation of the etching stopper layer 130 in this fourth embodiment are similar to those in the third embodiment.

Fig. 19 is a diagram for explaining the procedures up to the etching of the substrate 142 in the fourth embodiment of the present technology.

As illustrated in Fig. 19(a), the manufacturing system forms a 5000-nanometer (nm) silicon oxide layer covering the etching stopper layer 130 as an isolation film 152. The manufacturing system performs dry etching and CMP to eliminate a step on the upper surface of the isolation film 152 and flatten the upper surface.

As illustrated in Fig. 19(b), the manufacturing system forms an opening 212 at the end of the die 140. A portion of the opening 212 reaches the substrate 142 of the die 140, and the rest reaches the etching stopper layer 130. The positions of the openings 211 and 213 in the fourth embodiment are the same as in the third embodiment.

The manufacturing system removes the etching stopper layer 130 and etches the isolation film 151 exposed through the openings 211 to 213.

Then, the manufacturing system selects a gas for etching only silicon and etches the substrate 142, as illustrated in Fig. 19(c).

Fig. 20 is a diagram for explaining the procedures up to metal embedding and CMP in the second embodiment of the present technology.

At the same time, the manufacturing system etches the rewiring layers 141 and 120 up to the electrode pads of the wirings 143, 144, 121, and 122, respectively, as illustrated in a. Then, the manufacturing system forms through-vias 161 to 163 by embedding metal (copper) or CMP, as illustrated in Fig. 20(b).

By opening the end of the die 140 and forming the through-via 162, the die-side area of the through-via 162 and the area of the die-side electrode pad can be reduced compared to the third embodiment. This improves the degree of freedom in wiring within the die and allows the size of the die to be reduced.

As described above, according to the fourth embodiment of the present technology, since the through-via 162 is formed at the end of the die 140, the die-side area of the through-via 162 and the area of the die-side electrode pad can be reduced.

### <5. Example of application to mobile object>

The technology according to the present disclosure (the present technology) can be applied to various products. For example, the technology according to the present disclosure may be realized as a device equipped in any type of moving body such as an automobile, an electric vehicle, a hybrid electric vehicle, a motorcycle, a bicycle, a personal mobility device, an airplane, a drone, a ship, and a robot.

Fig. 21 is a block diagram showing a schematic configuration example of a vehicle control system, which is an example of a moving body control system to which the technique according to the present disclosure can be applied.

The vehicle control system 12000 includes a plurality of electronic control units connected thereto via a communication network 12001. In the example illustrated in Fig. 21, the vehicle control system 12000 includes a drive system control unit 12010, a body system control unit 12020, a vehicle exterior information detection unit 12030, a vehicle interior information detection unit 12040, and an integrated control unit 12050. In addition, as a functional configuration of the integrated control unit 12050, a microcomputer 12051, a sound/image output unit 12052, and an in-vehicle network interface (I/F) 12053 are illustrated.

The drive system control unit 12010 controls an operation of an apparatus related to a drive system of a vehicle according to various programs. For example, the drive system control unit 12010 functions as a driving force generator for generating a driving force of a vehicle such as an internal combustion engine or a driving motor, a driving force transmission mechanism for transmitting a driving force to wheels, a steering mechanism for adjusting a turning angle of a vehicle, and a control apparatus such as a braking apparatus that generates a braking force of a vehicle.

The body system control unit 12020 controls operations of various devices mounted in the vehicle body according to various programs. For example, the body system control unit 12020 functions as a control device of a keyless entry system, a smart key system, a power window device, or various lamps such as a headlamp, a back lamp, a brake lamp, a turn signal, and a fog lamp. In this case, radio waves transmitted from a portable device that substitutes for a key or signals of various switches may be input to the body system control unit 12020. The body system control unit 12020 receives inputs of the radio waves or signals and controls a door lock device, a power window device, and a lamp of the vehicle.

The vehicle exterior information detection unit 12030 detects information on the outside of the vehicle having the vehicle control system 12000 mounted thereon. For example, an imaging unit 12031 is connected to the vehicle exterior information detection unit 12030. The vehicle exterior information detection unit 12030 causes the imaging unit 12031 to capture an image of the outside of the vehicle and receives the captured image. The vehicle exterior information detection unit 12030 may perform object detection processing or distance detection processing for peoples, cars, obstacles, signs, and letters on the road on the basis of the received image.

The imaging unit 12031 is an optical sensor that receives light and outputs an electrical signal according to the amount of the received light. The imaging unit 12031 can also output the electrical signal as an image or distance measurement information. In addition, the light received by the imaging unit 12031 may be visible light or invisible light such as infrared light.

The vehicle interior information detection unit 12040 detects information on the inside of the vehicle. For example, a driver state detection unit 12041 that detects a driver's state is connected to the vehicle interior information detection unit 12040. The driver state detection unit 12041 includes, for example, a camera that captures an image of a driver, and the vehicle interior information detection unit 12040 may calculate a degree of fatigue or concentration of the driver or may determine whether or not the driver is dozing on the basis of detection information input from the driver state detection unit 12041.

The microcomputer 12051 can calculate a control target value of the driving force generator, the steering mechanism, or the braking device on the basis of information inside and outside of the vehicle acquired by the vehicle exterior information detection unit 12030 or the vehicle interior information detection unit 12040, and output a control command to the drive system control unit 12010. For example, the microcomputer 12051 can perform cooperative control for the purpose of realizing functions of an advanced driver assistance system (ADAS) including collision avoidance or impact mitigation of a vehicle, following traveling based on inter-vehicle distance, vehicle speed maintenance driving, vehicle collision warning, vehicle lane deviation warning, or the like.

Further, the microcomputer 12051 can perform cooperative control for the purpose of automated driving or the like in which autonomous travel is performed without depending on operations of the driver, by controlling the driving force generator, the steering mechanism, or the braking device and the like on the basis of information about the surroundings of the vehicle, the information being acquired by the vehicle exterior information detection unit 12030 or the vehicle interior information detection unit 12040.

In addition, the microcomputer 12051 can output a control command to the body system control unit 12020 based on the information acquired by the vehicle exterior information detection unit 12030 outside the vehicle. For example, the microcomputer 12051 can perform cooperative control for the purpose of preventing glare, such as switching from a high beam to a low beam, by controlling the headlamp according to the position of a preceding vehicle or an oncoming vehicle detected by the vehicle exterior information detection unit 12030.

The sound/image output unit 12052 transmits an output signal of at least one of sound and an image to an output device capable of visually or audibly notifying a passenger or the outside of the vehicle of information. In the example of Fig. 21, an audio speaker 12061, a display unit 12062, and an instrument panel 12063 are shown as examples of the output device. The display unit 12062 may include at least one of an on-board display and a head-up display, for example.

Fig. 22 is a diagram showing an example of an installation position of the imaging unit 12031.

In Fig. 22, imaging units 12101, 12102, 12103, 12104, and 12105 are provided as the imaging units 12031.

The imaging units 12101, 12102, 12103, 12104, and 12105 are provided at positions such as a front nose, side-view mirrors, a rear bumper, a back door, and an upper portion of a windshield in a vehicle interior of the vehicle 12100, for example. The imaging unit 12101 provided on the front nose and the imaging unit 12105 provided in the upper portion of the windshield in the vehicle interior mainly acquire images of the front of the vehicle 12100. The imaging units 12102 and 12103 provided on the side-view mirrors mainly acquire images of a lateral side of the vehicle 12100. The imaging unit 12104 provided on the rear bumper or the back door mainly acquires images of the rear of the vehicle 12100. The imaging unit 12105 provided in the upper portion of the windshield in the vehicle interior is mainly used for detection of preceding vehicles, pedestrians, obstacles, traffic signals, traffic signs, lanes, and the like.

Fig. 22 illustrates an example of imaging ranges of the imaging units 12101 to 12104. An imaging range 12111 indicates an imaging range of the imaging unit 12101 provided at the front nose, imaging ranges 12112 and 12113 respectively indicate the imaging ranges of the imaging units 12102 and 12103 provided at the side-view mirrors, and an imaging range 12114 indicates the imaging range of the imaging unit 12104 provided at the rear bumper or the back door. For example, by superimposing image data captured by the imaging units 12101 to 12104, it is possible to obtain a bird's-eye view image viewed from the upper side of the vehicle 12100.

At least one of the imaging units 12101 to 12104 may have a function for obtaining distance information. For example, at least one of the imaging units 12101 to 12104 may be a stereo camera constituted by a plurality of imaging elements or may be an imaging element that has pixels for phase difference detection.

For example, the microcomputer 12051 can extract, particularly, a closest three-dimensional object on a path along which the vehicle 12100 is traveling, which is a three-dimensional object traveling at a predetermined speed (for example, 0 km/h or higher) in the substantially same direction as the vehicle 12100, as a preceding vehicle by acquiring a distance to each of three-dimensional objects in the imaging ranges 12111 to 12114 and temporal change in the distance (a relative speed with respect to the vehicle 12100) on the basis of the distance information obtained from the imaging units 12101 to 12104. Further, the microcomputer 12051 can set an inter-vehicle distance which should be secured in front of the vehicle in advance with respect to the preceding vehicle and can perform automated brake control (also including following stop control) or automated acceleration control (also including following start control). In this way, it is possible to perform cooperative control for the purpose of automated driving or the like in which a vehicle autonomously travels without depending on operations of the driver.

For example, the microcomputer 12051 can classify and extract three-dimensional data regarding three-dimensional objects into two-wheeled vehicles, normal vehicles, large vehicles, pedestrians, and other three-dimensional objects such as electric poles based on distance information obtained from the imaging units 12101 to 12104 and can use the three-dimensional data to perform automated avoidance of obstacles. For example, the microcomputer 12051 differentiates surrounding obstacles of the vehicle 12100 into obstacles which can be viewed by the driver of the vehicle 12100 and obstacles which are difficult to view. Then, the microcomputer 12051 determines a collision risk indicating the degree of risk of collision with each obstacle, and when the collision risk is equal to or higher than a set value and there is a possibility of collision, an alarm is output to the driver through the audio speaker 12061 or the display unit 12062, forced deceleration or avoidance steering is performed through the drive system control unit 12010, and thus it is possible to perform driving support for collision avoidance.

At least one of the imaging units 12101 to 12104 may be an infrared camera that detects infrared rays. For example, the microcomputer 12051 can recognize a pedestrian by determining whether there is a pedestrian in the captured image of the imaging units 12101 to 12104. Such pedestrian recognition is performed by, for example, a procedure in which feature points in the captured images of the imaging units 12101 to 12104 as infrared cameras are extracted and a procedure in which pattern matching processing is performed on a series of feature points indicating an outline of an object to determine whether or not the object is a pedestrian. When the microcomputer 12051 determines that there is a pedestrian in the captured images of the imaging units 12101 to 12104 and the pedestrian is recognized, the sound/image output unit 12052 controls the display unit 12062 so that a square contour line for emphasis is superimposed and displayed with the recognized pedestrian. In addition, the sound/image output unit 12052 may control the display unit 12062 so that an icon indicating a pedestrian or the like is displayed at a desired position.

An example of the vehicle control system to which the technology according to the present disclosure can be applied has been described above. The technology according to the present disclosure can be applied, for example, to each imaging unit 12031 among the components described above. Specifically, a semiconductor device manufactured from the wafer 100 in Fig. 1 can be applied to the imaging unit 12031. By applying the technology according to the present disclosure to the imaging unit 12031, it is possible to prevent metal embedding defects and improve the reliability of the system.

It should be noted that the above-described embodiments show examples for embodying the present technology, and matters in the embodiments and matters specifying the invention in the claims have a corresponding relationship with each other. Similarly, the matters specifying the invention in the claims and the matters in the embodiments of the present technology having the same name have a corresponding relationship with each other. However, the present technology is not limited to the embodiments and can be embodied by applying various modifications to the embodiments without departing from the gist thereof.

The effects described in the present specification are merely examples and are not intended as limiting, and other effects may be obtained.

The present technology can also have the following configurations.
(1) A semiconductor device including:
   a substrate on which a rewiring layer is formed;
   an etching stopper layer formed on a bonding surface of the rewiring layer;
   a die bonded to a partial region of the bonding surface via the etching stopper layer; and
   an isolation film covering the die and the etching stopper layer.
(2) The semiconductor device according to (1), further including:
   a substrate-side via penetrating the isolation film and the etching stopper layer and having one end connected to a wiring in the rewiring layer; and
   a die-side via penetrating the isolation film, the die, and the etching stopper layer and
   having one end connected to the wiring in the rewiring layer.
(3) The semiconductor device according to (2), wherein
   the die-side via is formed at a location that does not correspond to an end of the die.
(4) The semiconductor device according to (2), wherein
   the die-side via is formed at an end of the die.
(5) The semiconductor device according to any one of (1) to (4), wherein
   an etching rate when etching the etching stopper layer with a predetermined etching gas is lower than an etching rate when etching the isolation film with the etching gas.
(6) The semiconductor device according to (5), wherein
   the isolation film is a silicon oxide film, and
   the etching stopper layer is a layer of silicon nitride, silicon carbide, or silicon carbonitride.
(7) A semiconductor device including:
   a substrate on which a rewiring layer is formed;
   a die bonded to a partial region of a bonding surface of the rewiring layer;
   a first isolation film covering the die and the rewiring layer;
   a second isolation film; and
   an etching stopper layer formed between the first isolation film and the second isolation film and having a step near an end of the die.
(8) The semiconductor device according to (7), further including:
   a substrate-side via penetrating the first isolation film and the second isolation film and the etching stopper layer and having one end connected to a wiring in the rewiring layer; and
   a die-side via penetrating the first isolation film and the second isolation film, the etching stopper layer, and the die and having one end connected to the wiring in the rewiring layer.
(9) The semiconductor device according to (8), wherein
   the die-side via is formed at a location that does not correspond to an end of the die.
(10) The semiconductor device according to (8), wherein
   the die-side via is formed at an end of the die.
(11) A method for manufacturing a semiconductor device, including:
   an etching stopper layer forming procedure for forming an etching stopper layer on a bonding surface of a rewiring layer formed on a substrate;
   a bonding procedure for bonding a die to a partial region of the bonding surface via the etching stopper layer; and
   an isolation film forming procedure for forming an isolation film covering the die and the etching stopper layer.
(12) A method for manufacturing a semiconductor device, including:
   a bonding procedure for bonding a die to a partial region of a bonding surface of a rewiring layer formed on a substrate;
   a first isolation film forming procedure for forming a first isolation film covering the die and the rewiring layer;
   an etching stopper layer forming procedure for forming an etching stopper layer having a step near an end of the die; and
   a second isolation film forming procedure for forming a second isolation film covering the etching stopper layer.

### [Reference Signs List]

100 Wafer
110, 142 Substrate
120, 141 Rewiring layer
121, 122, 143, 144 Wiring
130 Etching stopper layer
140 Die
151, 152 Isolation film
160 Seed layer
161 to 163 Through-via
171 to 173 Sidewall
211 to 213 Opening
220 Resist

## Claims

1. A semiconductor device comprising:
a substrate on which a rewiring layer is formed;
an etching stopper layer formed on a bonding surface of the rewiring layer;
a die bonded to a partial region of the bonding surface via the etching stopper layer; and
an isolation film covering the die and the etching stopper layer.

2. The semiconductor device according to claim 1, further comprising:
a substrate-side via penetrating the isolation film and the etching stopper layer and having one end connected to a wiring in the rewiring layer; and
a die-side via penetrating the isolation film, the die, and the etching stopper layer and
having one end connected to the wiring in the rewiring layer.

3. The semiconductor device according to claim 2, wherein
the die-side via is formed at a location that does not correspond to an end of the die.

4. The semiconductor device according to claim 2, wherein
the die-side via is formed at an end of the die.

5. The semiconductor device according to claim 1, wherein
an etching rate when etching the etching stopper layer with a predetermined etching gas is lower than an etching rate when etching the isolation film with the etching gas.

6. The semiconductor device according to claim 5, wherein
the isolation film is a silicon oxide film, and
the etching stopper layer is a layer of silicon nitride, silicon carbide, or silicon carbonitride.

7. A semiconductor device comprising:
a substrate on which a rewiring layer is formed;
a die bonded to a partial region of a bonding surface of the rewiring layer;
a first isolation film covering the die and the rewiring layer;
a second isolation film; and
an etching stopper layer formed between the first isolation film and the second isolation film and having a step near an end of the die.

8. The semiconductor device according to claim 7, further comprising:
a substrate-side via penetrating the first isolation film and the second isolation film and the etching stopper layer and having one end connected to a wiring in the rewiring layer; and
a die-side via penetrating the first isolation film and the second isolation film, the etching stopper layer, and the die and having one end connected to the wiring in the rewiring layer.

9. The semiconductor device according to claim 8, wherein
the die-side via is formed at a location that does not correspond to an end of the die.

10. The semiconductor device according to claim 8, wherein
the die-side via is formed at an end of the die.

11. A method for manufacturing a semiconductor device, comprising:
an etching stopper layer forming procedure for forming an etching stopper layer on a bonding surface of a rewiring layer formed on a substrate;
a bonding procedure for bonding a die to a partial region of the bonding surface via the etching stopper layer; and
an isolation film forming procedure for forming an isolation film covering the die and the etching stopper layer.

12. A method for manufacturing a semiconductor device, comprising:
a bonding procedure for bonding a die to a partial region of a bonding surface of a rewiring layer formed on a substrate;
a first isolation film forming procedure for forming a first isolation film covering the die and
the rewiring layer;
an etching stopper layer forming procedure for forming an etching stopper layer having a step near an end of the die; and
a second isolation film forming procedure for forming a second isolation film covering the etching stopper layer.
